# EUROPEAN PATENT APPLICATION

(11) **EP 4 721 873 A1**
(43) Date of publication of application: **08.04.2026**
(21) Application number: 25205332.7
(22) Date of filing: 29.09.2025
(51) Int. Cl.: B05B 12/36, B05B 13/02, C23C 14/04, C23C 14/34, C23C 14/50, C23C 14/56, H01J 37/32

(54) **APPARATUS AND METHOD FOR THE APPLICATION OF SURFACE TREATMENTS ON ARTICLES**

(30) Priority: 07.10.2024 IT 202400022161; 20.11.2024 IT 202400026160
(71) Applicant: TAPEMATIC S.p.A., 20876 Ornago (Monza Brianza) (IT)
(72) Inventor: PEREGO, Luciano, 23807 MERATE (LECCO) (IT)
(74) Representative: Tansini, Elio Fabrizio

(57) **Abstract**

In an apparatus (1) for applying surface treatment to articles, a decoration module (4), configured to apply a surface treatment to articles (K) carried by each treatment tray (3) comprises: a handler (6) for the treatment trays (3), configured to move the treatment trays (3) along a working path (L); a first treatment zone (7), provided with a first metallising device (71) designed to perform a first metallisation processing; and a second treatment zone (8) provided with a second metallising device (81), designed to perform a second metallisation processing.

## Description

The present invention relates to an apparatus for applying surface treatments to articles.

The present invention also relates to a method for applying surface treatments to articles.

Currently, the use of articles with a high degree of surface finish is in high demand, for example in the pharmaceutical or cosmetics sector.

Such articles may, for example, comprise caps, lids, bottles, tubes, or containers of other type.

The surface finish of the articles can be made by means of a metallisation processing, that is, a surface finish processing capable of completely transforming the surface of the article by embellishing it and enhancing its appearance so that it looks more sophisticated and valuable.

Metallization makes it possible to perfectly imitate other types of colours, for example those obtained through the process of the galvanic baths, thus making it possible to aesthetically assimilate articles made of "poor" material (whether plastic or metal) to articles of higher value (for example chrome or gold).

Nowadays, it is possible to perform the metallisation of articles by means of the sputtering technique, which provides for an emission of metal particles, such as atoms, ions or molecular fragments, from a target element made of a material with which the article is to be coated.

The emission of metal particles from the target element is obtained by directing a beam of energetic particles (generally ions) onto the target element itself.

The energetic particles, by hitting the target element, erode from it metal particles that are deposited on the surfaces of the article to be coated, metallising it.

Sputtering is carried out in a high vacuum chamber.

Generally, it is known to perform sputtering downstream of the application of a primer on the article to be metallised, for example performed by spray painting.

It is also known to perform, downstream of sputtering, a painting process to coat the metallised article with a protective layer.

Traditional apparatuses comprise a single metallisation station defining a chamber within which the articles are placed and within which a sputtering processing is performed.

In detail, the articles to be metallised within the chamber of the metallisation station are arranged in succession along a single row and are each rotated around their main development axis, so that it is possible to perform the metallisation processing in a homogeneous manner over their entire external surface.

It follows that the traditional apparatuses, requiring the articles being arranged along a single row, suffer from the drawback of limiting the number of articles that can be metallised at the same time.

This limitation significantly compromises the degree of efficiency and productivity of the apparatus.

In fact, while a few seconds are required for the actual metallisation process, the time required to create the vacuum inside the chamber in which metallisation is performed is a few minutes, that is, at least an order of magnitude greater than the metallisation time.

Considering that the amount of energy required to depressurize the metallisation chamber is quite considerable, the need to metallise as many articles as possible at the same time is evident.

The Applicant has therefore found that the apparatus and methods for applying surface treatments to articles suffer from the drawback of limited efficiency and productivity.

Nowadays, the articles to be metallised often have a discontinuous surface, having ridges and/or depressions adapted to detail the article so as to identify it with a specific line of products.

The metallisation of these types of articles is particularly complex since the metal particles emitted by the target element could deposit on their discontinuous surface in an inhomogeneous manner.

The Applicant has therefore found that the apparatus and methods for applying surface treatments to articles are not able, especially in the case of articles having a discontinuous surface, to guarantee a high level of quality of metallisation.

The technical task of the present invention is thus to make available an apparatus and a method for applying surface treatments which are able to overcome the drawbacks which have emerged from the prior art.

An object of the present invention is to increase the productivity and efficiency of the production processes for obtaining metallised articles.

An object of the present invention is to increase the level of quality of the metallisation processes.

More particularly, in accordance with one aspect, an apparatus for applying surface treatments to articles is an object of the present invention.

The apparatus comprises a plurality of treatment trays, each designed to removably engage a plurality of articles.

The apparatus comprises a decoration module, configured to apply a surface treatment to articles carried by each of the treatment trays.

The decoration module comprises a handler for the treatment trays, configured to move the treatment trays along a working path.

The decoration module comprises at least a first treatment zone and a second treatment zone, arranged in succession along the working path.

The first treatment zone has a first workstation, designed to receive the treatment trays, and a first metallising device, arranged within the first workstation and designed to perform a first metallisation processing on the articles carried by the treatment tray housed in the first workstation.

The second treatment zone is provided with a second workstation, designed to receive the treatment trays, and a second metallising device, arranged within the second workstation and designed to perform a second metallisation processing on the articles carried by the treatment tray housed in the second workstation.

Advantageously, the first and second treatment zones allow performing two metallisation processings that are identical between them, allowing a high quality of metallisation to be obtained even in the case where the articles to be metallised have a discontinuous surface. Alternatively, the first and second treatment zones allow performing two metallisation processings that are different from one another, allowing an article to be obtained with a more distinguishable and attractive appearance.

At least one convenient embodiment of the invention may further comprise one or more of the preferred technical solutions listed below.

Preferably, the first and second workstations respectively comprise a first and a second chamber, configured to individually house said treatment trays.

Preferably, each treatment tray has opposite sides, respectively.
Preferably, the first and second metallising devices each operate on a single one of said respectively opposite sides of the treatment tray arranged along the working path.

Advantageously, this arrangement of the first and second metallising devices allows to metallise articles arranged along rows of articles that are opposite with respect to the working path.

Preferably, the first and second metallising devices are each designed to emit a beam of metal particles.

Preferably, the first metallising device comprises an energetic particle emitter and a target element.

Preferably, the second metallising device comprises an energetic particle emitter and a target element.

The target element is intended to be hit by the energetic particles emitted by the emitter.

Preferably, the target element of the first metallising device and the target element of the second metallising device are placed laterally alongside a portion of the working path and face it in respectively opposite directions, i.e. from respectively opposite positions.

In other words, the target element of the first metallising device is positioned in a position opposite, with respect to a portion of the working path along which the first and second treatment zones are arranged, to the target element of the second metallising device.

Preferably, the working path extends according to a closed line.

Preferably, the first and second treatment zones respectively form a first and a second treatment station.

Preferably, the target element of the first metallising device is arranged inside the closed line.

Preferably, the target element of the second metallising device is arranged outside the closed line.

Preferably, each treatment tray comprises a plurality of support members, each designed to releasably engage one of the articles.

Preferably, each support member comprises a spindle, designed to engage an article.

Thus, each treatment tray is designed to removably engage a plurality of articles, each engaged with a spindle.

Preferably, each support member also comprises a pin, or other suitable connection elements, and each spindle has a seat designed to receive the pin of the support member through insertion, or to connect with the other suitable connection elements.

In other words, each support member preferably comprises a pin carried by the treatment tray and reversibly engageable with a spindle designed to removably engage an article along a geometric axis common thereto.

Preferably, the pin is rotatable to determine a rotation of the spindle together with the article around said geometric axis.

Consequently, the articles can conveniently rotate each one around the respective geometric axis during metallisation processings, to the advantage of a homogeneous distribution of the metal particles over their surface extension.

In accordance with one aspect, each treatment tray is designed to removably engage a plurality of articles arranged along two rows placed in parallel alongside one another.

Preferably, the support members of the treatment tray are positioned along two rows placed in parallel alongside one another.

Preferably, each treatment tray engaged on the handler is oriented with the two rows of articles arranged in parallel to the working path.

In other words, the rows of articles are parallel to an advancement direction of the treatment tray, or to a tangent thereof when the advancement direction has a curved development.

More precisely, the rows of articles and/or support members are parallel to said advancement direction or to the tangent thereof, in at least a portion of the working path that crosses the first and treatment zone and/or the second treatment zone.

Preferably, the first metallising device is configured to perform a first metallisation processing mainly or exclusively on the articles arranged along one of the two rows and the second metallising device is configured to perform a second metallisation processing mainly or exclusively on the articles arranged along the other of the two rows.

In accordance with one aspect, each treatment tray is designed to removably engage a plurality of articles arranged along a single row.

Preferably, the support members of the treatment tray are positioned along a single row.

Preferably, each treatment tray engaged on the handler is oriented with the single row of articles arranged in parallel to the working path.

In other words, the single row of articles is parallel to an advancement direction of the treatment tray.

Preferably, the first metallising device operates a first metallisation processing, mainly or exclusively on the articles arranged along the single row and the second metallising device operates a second metallisation processing, different from the first, mainly or exclusively on the articles arranged along a single row.

Preferably, the decoration module comprises at least one deflector element, arranged within at least one of the first and second workstations and designed to intercept the metal particles directed towards a predetermined portion of each article.

In other words, the deflector element is designed to shield a portion of each article from the emitted particles.

Preferably, the apparatus comprises a supply line designed to supply a plurality of articles.

Preferably, the supply line comprises a plurality of supply trays, each designed to removably engage a plurality of articles arranged along a single row, and a movement element, configured to move the supply trays along a supply path.

Preferably, the supply path is linear and faces the working path.

Preferably, the apparatus comprises a transfer unit operating on the articles supplied by the supply line to take them from the supply line and transfer them to a treatment tray.

Preferably, the transfer unit operates on each of the treatment trays carrying the transferred articles, to transfer it to the decoration module.

Preferably, the transfer unit operates on a first row of articles to take it from the supply line and transfer it to one of the treatment trays, and on a second row of articles to take it from the supply line and transfer it to the same treatment tray in parallel alongside the first transferred row.

Preferably, the transfer unit comprises a transferor designed to move a plurality of treatment trays along a transfer path between a supply position, near the supply line, and a transfer position, near the decoration module. Preferably, the transferor is designed to move a plurality of treatment trays along a transfer path extending along a closed line.

Preferably, the transfer unit comprises a first manipulator and a second manipulator.

The first manipulator operates near the supply position to take the supply articles from the supply line and transfer them to a treatment tray.

The second manipulator operates near the transfer position to transfer to the decoration module each of the treatment trays carrying the articles transferred by the first manipulator.

Preferably, the handler is configured to move the treatment trays along the working path up to a loading/unloading position arranged along the working path.

Preferably, the second manipulator simultaneously operates on a treatment tray carried by the transferor to transfer it from the transfer position to the loading/unloading position, and on a treatment tray carried by the decoration module to transfer it from the loading/unloading position to the transfer position.

Preferably, the first manipulator simultaneously operates on the articles carried by one of the treatment trays, to transfer them to the supply line, and on the articles carried by the supply line, to transfer them to the treatment tray.

Preferably, the first manipulator develops around its own first switching axis.

Preferably, the first manipulator comprises two grasping members, each radially spaced from the first switching axis.

Preferably, the apparatus comprises a first switching device active on the first manipulator and configured to move the grasping members of the first manipulator with 180° rotations around the first switching axis between a first and a second position.

In the first position, the grasping member takes and/or releases a row of articles from and/or to the supply line.

In the second position, the grasping member takes and/or releases a row of articles from and/or to one of the treatment trays carried by the transfer unit.

Preferably, the first manipulator comprises one or more lifting actuators each operating on the grasping members to translate them, individually or simultaneously, towards or away from the transfer path.

Preferably, each grasping member comprises a first and a second arm facing in parallel.

Preferably, the first and second arms are movable independently of each other towards and away from each other, preferably by means of respective transverse movement actuators.

Preferably, the first and second arms carry respective mutually opposed gripping elements, arranged to grasp the individual articles.

Preferably, the gripping elements are provided with magnetic elements designed to define a magnetic connection with the article to be grasped.

Preferably, the gripping elements of the first arm extend cantilevered towards the first switching axis.

Preferably, the gripping elements of the second arm extend cantilevered towards the first switching axis.

Preferably, the gripping elements of the first arm lend themselves to operating on a first row of articles carried by a treatment tray and the gripping elements of the second arm lend themselves to operating on a second row of articles carried by the same treatment tray, wherein the first and second rows are parallel to each other.

In accordance with one aspect, a method for applying surface treatments to articles is an object of the present invention.

The method comprises a step of preparing a plurality of articles.

The method comprises a step of transferring the articles to a treatment tray, which is designed to removably engage a plurality of articles.

The method comprises a step of moving the treatment tray carrying the articles along a working path and, simultaneously, performing a first and a second metallisation processing on the articles carried by the treatment tray.

The first and second metallisation processing are performed in respective treatment zones arranged consecutively along the working path.

Preferably, the articles are transferred onto the treatment tray to form a first row and a second row placed in parallel alongside one another.

Preferably, the first and second metallisation processing are each performed mainly on the first and on the second row of articles respectively by projection of metal particles from respectively opposite positions.

Preferably, the first and second metallisation processing are performed on a first portion and a second portion, respectively, of each of the articles carried by the treatment tray.

Preferably, the method is performed by the apparatus for applying surface treatments to articles.

Additional features and advantages of the present invention will emerge more clearly from the approximate and thus non-limiting description of an embodiment of an apparatus and a method for applying surface treatments to articles.

Such description will be set forth herein below with reference to the accompanying drawings, provided for merely indicative and therefore non-limiting purposes, wherein:
- figure 1 shows a perspective view of an apparatus for applying surface treatments to articles in accordance with the present invention;
- figure 2 shows a top view of the apparatus of figure 1;
- figure 3 shows a further perspective view of the apparatus of figure 1, deprived of some components to highlight others;
- figures 4 and 5 show the respective details of figure 1;
- figures 6-13 show operating positions of a component of the apparatus of figure 1;
- figure 14 shows a component of the apparatus of figure 1;
- figures 15 and 16 schematically show a cross-section of a first workstation.

With reference to the attached figures, an apparatus for applying surface treatments to articles in accordance with the present invention has been indicated overall with reference numeral 1.

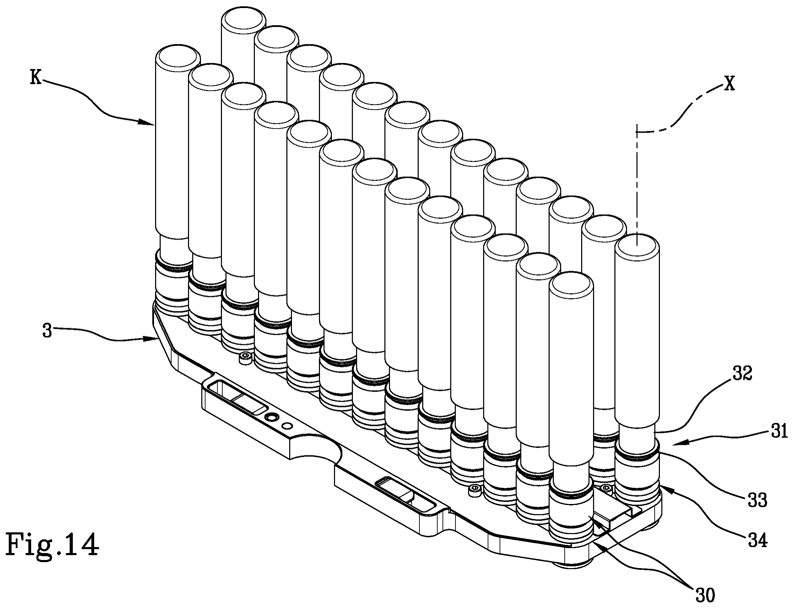

The apparatus 1 comprises a supply line 2 designed to supply a plurality of articles indicated with K and better illustrated in figure 14.

The articles K are advanced along the supply line 2, for example by means of one or more continuous belt conveyors, chain conveyors or other suitable movement devices.

In the illustrated example, the supply line 2 comprises a plurality of supply trays 20, each designed to removably engage the articles K arranged along a single row, and a movement device 21, configured to move the supply trays 20 along a supply path A.

In the illustrated example, the supply path A is linear. Preferably the supply path A is straight.

The apparatus 1 comprises a plurality of treatment trays 3, each designed to removably engage a plurality of articles K.

The articles K are therefore transferred from the supply line 2 to the treatment trays 3.

The transfer of the articles K can be performed manually or, as better described below, automatically in a loading/unloading region R defined along the supply line 2, between an inlet section I and an outlet section U respectively consecutive.

In order to engage the articles K, each treatment tray 3 comprises a plurality of support members 30 (figure 14).

Each support member 30 is designed to removably engage an article K.

Each support member 30 comprises a spindle 31 designed to removably engage an article K.

Structurally, each spindle 31 may comprise a stem 32 coaxially insertable into one of the articles K to properly support and retain it so that a geometric axis of the article K coincides with a geometric axis X of the spindle 31 itself.

The stem 32 rises from a base portion 33 defining a lower end of the spindle 31.

The base portion 33 comprises a connection region coaxial to the geometric axis X of the spindle 31 and designed to be reversibly connected with the treatment tray 3.

Each support member 30 also comprises a connection element 34 engaged with the treatment tray 3 and designed to be reversibly connected to the spindle 31.

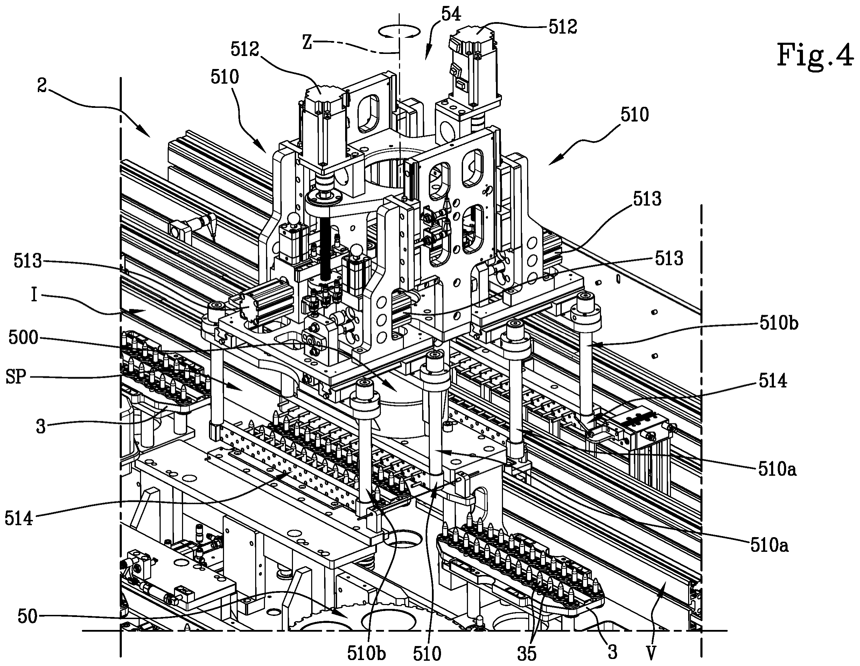

For example, the connection element 34 comprises a pin 35 (figures 4, 5 and 8) carried by the treatment tray 3 and the connection region of the spindle 31 is provided with a seat designed to receive the pin 35 through insertion.

The pin 35 is rotatable about its own geometric axis and a rotation of the pin 35 causes a rotation of the spindle 31 carried by the pin 35 with consequent rotation of the article K fitted on the spindle 31.

The apparatus 1 comprises a decoration module 4 configured to apply a surface treatment to the articles K carried by each of the treatment trays 3. In order to transfer the treatment trays 3 carrying the articles K to be processed, the apparatus 1 comprises a transfer unit 5 interposed between the supply line 2 and the decoration module 4 and operating on the articles K supplied by the supply line 2, to take them from the supply line 2 and transfer them to the individual treatment trays 3. The transfer unit 3 also lends itself to operating on each treatment tray 3 carrying the transferred articles K, to transfer the treatment tray 3 to the decoration module 4.

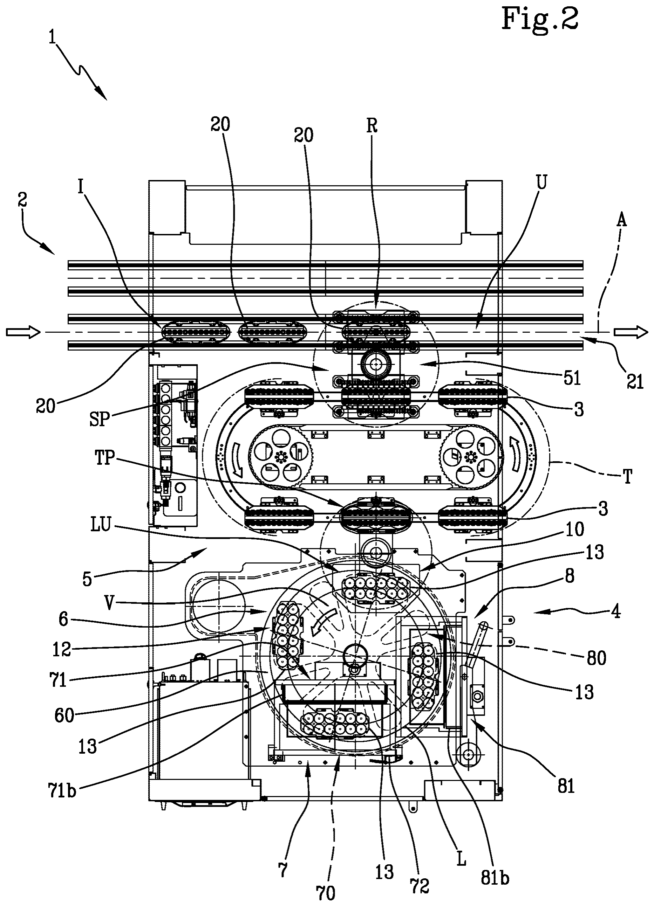

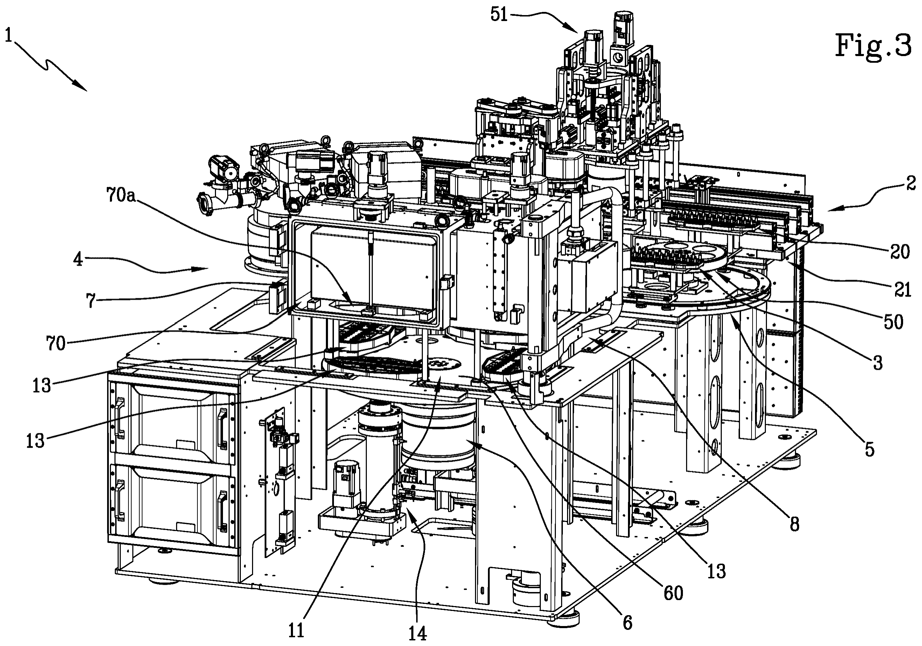

As best seen in figures 2 and 3, the decoration module 4 comprises a handler 6 configured to move the treatment trays 3 according to a predetermined movement direction V, along a working path L.

In the illustrated example, the working path L extends according to a closed line. Preferably, the working path L starts and ends at least at a loading/unloading position LU.

The decoration module 4 comprises at least a first 7 and at least a second 8 treatment zone arranged in succession along the working path L. Each of the first 7 and second 8 treatment zones is preferably made in the form of a station, at which the treatment trays 3 moved along the working path L stop for performing the processing on the articles K.

The second treatment zone 8 is arranged along the working path L downstream of the first treatment zone 7, with reference to the movement direction V.

The first treatment zone 7 is provided with a first workstation 70, designed to receive the treatment trays 3, and a first metallising device 71, arranged within the first workstation 70 and designed to perform a first metallisation processing on the articles K carried by the treatment tray 3 in the first workstation 70.

The second treatment zone 8 is provided with a second workstation 80, designed to receive the treatment trays 3, and a second metallising device 81, arranged within the second workstation 80 and designed to perform a second metallisation processing on the articles K carried by the treatment tray 3 in the second workstation 80.

In the illustrated example, the first 70 and the second 80 workstation are respectively made in the form of a first and a second chamber, configured to individually house treatment trays 3. The first 71 and the second 81 metallising device are configured to perform a metallisation processing of the type usually called sputtering, also identified with the acronym PVD (Physical Vapor Deposition).

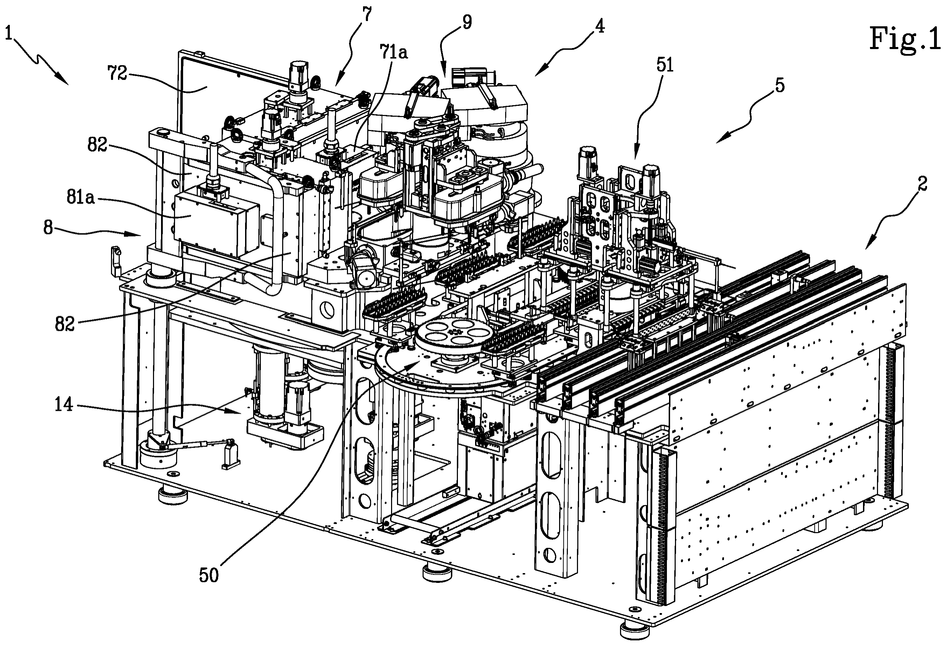

Thus, the first 71 and the second 81 metallising device each comprise an energetic particle emitter 71a, 81a (figure 1) and a target element 71b, 81b intended to be hit by the energetic particles emitted by the emitter.

The target element 71b, 81b comprises a solid body of metallic material, for example aluminium.

The target element 71b, 81b, hit by the energetic particles, emits metal particles that are deposited on the articles K carried by the treatment tray 3.

In order to allow the replacement of the target element 71b, 81b, and the maintenance of the first 71 and the second 81 metallising device, the first 70 and the second 80 workstation each comprise a hermetically sealed access door 72, 82 (figure 1).

The target element 71b of the first metallising device 71 and the target element 81b of the second metallising device 81 are placed laterally alongside a portion of the working path L and face it in respectively opposite directions.

Therefore, the target element 71b of the first metallising device 71 is positioned in a position opposite, with respect to a portion of the working path L along which the first 7 and second 8 treatment zones are arranged, to the target element 81b of the second metallising device 81.

In the illustrated example, where the working path L extends along a closed line, the target element 71b of the first metallising device 71 is arranged inside the closed line, while the target element 81b of the second metallising device 81 is arranged outside the closed line.

The first workstation 70 and the second workstation 80 are in a vacuum condition.

In order to bring the first 70 and the second 80 workstation into a vacuum condition, the apparatus 1 comprises a depressurization unit 9 operatively associated with the first 70 and the second 80 workstation to bring them into a forced vacuum condition.

In order to maintain the first 70 and the second 80 workstation in a permanent vacuum condition, thereby decreasing the costs for operating the apparatus 1, the decoration module 4 comprises at least one loading/unloading chamber 10 (figure 2) placed along the working path L at the loading/unloading position LU, and a movement chamber 11 (figure 3) that houses the working path L. The movement chamber 11 can be hermetically isolated with respect to the loading/unloading chamber 10 and communicates with the first 70 and the second 80 workstation.

The depressurization unit 9 is operatively associated with the loading/unloading chamber 10 to bring it from the ambient pressure condition to the vacuum condition.

The movement chamber 11 is maintained in a permanent vacuum condition together with the first workstation 70 and the second workstation 80 and, in a known manner, allows a transfer of the treatment trays 3 from the loading/unloading chamber 10 to the movement chamber 11, in addition to the transfer of the treatment trays 3 to the first 70 to the second 80 treatment workstation in succession.

In the illustrated example, the decoration module 4 comprises a conditioning station 12 arranged along the working path L upstream, with respect to the movement direction V, of the first 7 and the second 8 treatment zone.

In the conditioning station 12, preferably interposed between the loading/unloading chamber 10 and the first treatment zone 7, the articles K are cleaned and/or subjected to preparation treatments such as, for example, evaporation of solvents or degassing.

The conditioning station 12 is at least partly defined within the movement chamber 11.

Thus, the conditioning station 12 is maintained in a permanent vacuum condition.

Structurally, in order to move the treatment trays 3 along the working path L, the handler 6 comprises a rotating table 60 arranged within the movement chamber 11.

The rotating table 60 develops around its own geometric axis and is movable in rotation around it, preferably according to a step-by-step movement.

The working path L is circular and develops around the geometric axis of the rotating table 60.

The decoration module 4 is provided with support plates 13, integral with the rotating table 60 and arranged along the working path L; therefore, a rotation of the rotating table 60 around its geometric axis causes a movement of the support plates 13 along the working path L.

Preferably, the support plates 13 are in number equal to the number of stations/chambers of the decoration module 4.

The apparatus 1 therefore allows the processings to be performed simultaneously in each treatment zone/workstation of the decoration module 4. It follows that, advantageously, the apparatus 1 is efficient and with high productivity.

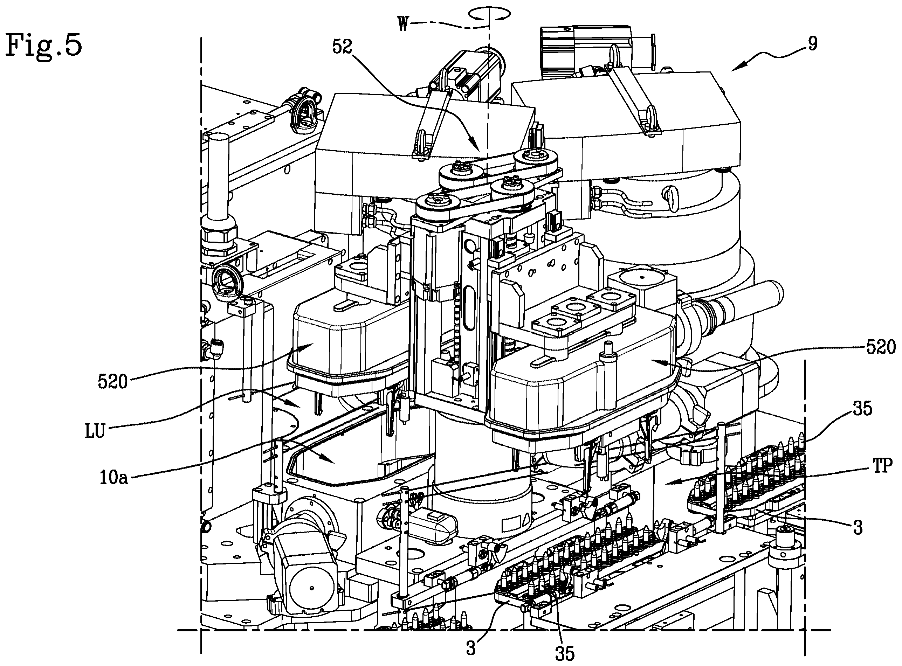

The loading-unloading chamber 10 is conveniently arranged in an elevated position with respect to the rotating table 13 and has its own opening 10a (figure 5) designed to put it in communication with the movement chamber 11.

The first workstation 70 is also preferably made in the form of a chamber arranged in an elevated position with respect to the rotating table 60 and has its own opening 70a (figure 3) designed to put it in communication with the movement workstation 11.

Similarly, the second workstation 80 is made in the form of a chamber arranged in an elevated position with respect to the rotating table 13 and has its own opening (not indicated in the drawings) designed to put it in communication with the movement workstation 11.

The decoration module 4 is provided with translation members 14, for example in the form of fluid-dynamic cylinders, configured to operate on the support plates 13 at least at the loading/unloading chamber 10, the first workstation 70 and the second workstation 80, to move said support plates 13, simultaneously or independently of each other, between a lowered position and a raised position. In the respective lowered position, each support plate 13 (and the retaining tray 3 carried by it) is placed inside the movement chamber 11 to be transferred along the working path L as a result of the rotation of the rotating table 13. In the raised position, the support plate 13 (and the retaining tray 3 carried by it) is arranged within the respective loading/unloading chamber 10, first workstation 70 or second workstation 80.

In order to allow a deposition of metal particles emitted by the target element 71b, 81b, each support plate 13 comprises a rotation unit (not indicated in the drawings as known) configured to engage with the base portions 33 of the spindles 31 and cause a rotation of each spindle 31 around its geometric axis X.

In accordance with an embodiment, as best seen in figure 14, each treatment tray 3 is designed to removably engage a plurality of articles K arranged along two rows placed in parallel alongside one another. Therefore, the support members 30 of the treatment tray 3 are correspondingly positioned along two rows placed in parallel alongside one another.

Each of said rows comprises three or more articles K, preferably 5 to 15 articles K.

The rows of articles K are parallel to an advancement direction of the treatment tray 3 or, as can be seen in figure 3 in which the working path is circular, to a direction tangent to the same advancement direction. This circumstance occurs at least in a portion of the working path L that crosses the first treatment zone 7 and/or the second treatment zone 8.

Specifically, each treatment tray 3 is engaged on the handler 6 of the decoration module 4 oriented with the two rows of articles K arranged in parallel to the working path L.

The opposite positioning of the target elements 71b, 81b belonging respectively to the first 71 and to the second 81 metallising device favours an optimal execution of the metallisation on the articles K arranged on both rows, without the presence of the articles K of each row compromising the correct deposition of the metal particles on the articles K of the other row.

In fact, the first metallising device 71 lends itself to performing a first metallisation processing mainly or exclusively on the articles K arranged along one of the two rows, while the second metallising device 81 lends itself to performing a second metallisation processing mainly or exclusively on the articles K arranged along the other of the two rows.

Advantageously, the apparatus 1 allows to duplicate the productivity as it allows, in the same processing cycle, to metallise the articles K of one row in the first treatment zone 7 and to metallise the articles K of the other row in the second treatment zone 8.

The transfer unit 5 comprises a transferor 50 (figure 4) designed to move, for example by means of a drive belt, a plurality of treatment trays 3 along a transfer path T extending, preferably along a closed line, between a supply position SP, located near the loading/unloading region R of the supply line 2, and a transfer position TP, located near the loading/unloading position LU of the working path L.

The treatment trays 3 are continuously recirculated according to a step-by-step movement along the entire transfer path T and along the working path L. More specifically, the treatment trays 3 perform the transfer path T by translating from the supply position SP to the transfer position TP and, subsequently, from the latter back to the supply position SP, after accessing and leaving the working path L at the loading/unloading position LU.

The transferor 50 acts as a buffer, i.e. it is adapted to store the treatment trays 3 between the supply position SP and the transfer position TP waiting for them to be transferred to the decoration module 4.

In the illustrated example, each of the supply trays 20 is designed to removably engage a plurality of articles K arranged along a single row. In this circumstance, in order to transfer the articles K from the supply line 2 to the decoration module 4, the transfer unit 5 comprises a first manipulator 51 operating between the supply position SP and the loading/unloading region R.

Structurally, the first manipulator 51, better illustrated in figure 4, develops around its own first switching axis Z and comprises two grasping members 510, each radially spaced from the first switching axis Z.

A first switching device 500 active on the first manipulator 51 lends itself to moving its grasping members 510 with 180° rotations around the first switching axis Z, between a first position in which the grasping member 510, near the loading/unloading region R, takes or releases a row of articles K to the supply line 2, and a second position in which the grasping member 510, near the transferor 50, takes or releases a row of articles K to one of the treatment trays 3 placed in the supply position SP.

One or more lifting actuators 512 operate on the grasping members 510 to translate them, individually or simultaneously, along an upward or downward vertical direction, i.e. towards or away from the transfer path T. Preferably, each grasping member 510 comprises a first 510a and a second 510b arm that are facing in parallel movable independently of each other by means of respective transverse movement actuators 513.

The first 510a and the second 510b arm carry respective mutually opposed gripping elements 514, arranged to grasp the individual articles K, possibly provided with magnetic elements designed to define a magnetic connection with the article K to be grasped.

The gripping elements 514 of the first arm 510a extend cantilevered towards the first switching axis Z, and lend themselves to operating on the first rows of articles K which, on the respective treatment trays 3, are positioned outside the transfer path T. In turn, the gripping elements 514 of the second arm 510b extend cantilevered away from the first switching axis Z, and lend themselves to operating on the second rows of articles K which, on the respective treatment trays 3, are positioned inside the transfer path T.

A typical example of operation of the first manipulator 51 is as follows.

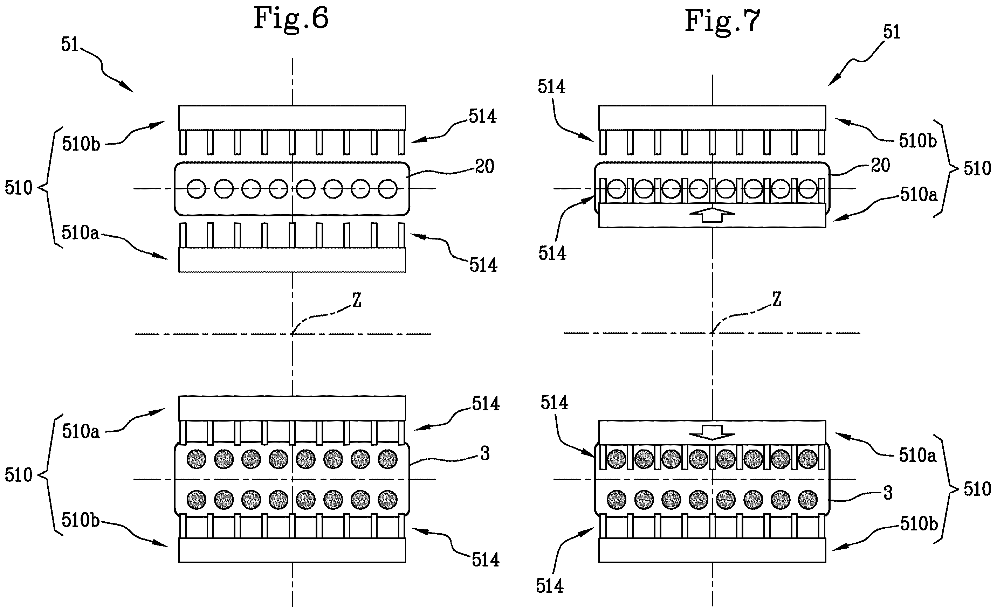

With reference to figure 7, when the grasping member 510 is in the first position, the first arm 510a translates away from the first switching axis Z upon command of the respective transverse movement actuator 513, to engage the first row of articles K to be metallised, carried by the supply tray 20 in the loading/unloading region R.

At the same time, the first arm 510a of the other grasping member 510 translates away from the first switching axis Z to engage the first row of already metallised articles K (illustrated in grey in figure 7), carried by the transfer tray 3 in the supply position SP.

Following a lifting motion imposed on the first arms 510a by the lifting actuators 512, the first rows of articles K are removed from the supply tray 20 and the transfer tray 3, respectively.

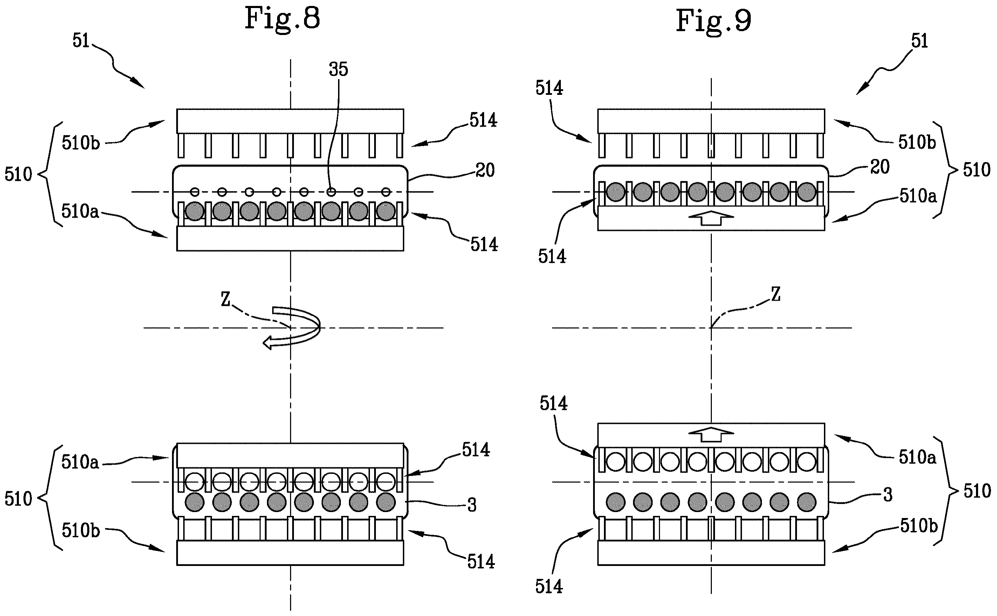

With reference to figure 8, following a 180° rotation of the grasping members 510 about the first switching axis Z, the first row of articles K to be metallised takes the place of the first row of metallised articles K (illustrated in grey in figure 8), and vice versa. A possible radial translation of the first arms 510a (figure 9) brings the articles K into axial alignment with the respective support members 30 carried by the transfer 3 and supply 20 tray, after which a new downward movement imposed on the first arms 510a positions the first row of articles K to be metallised on the transfer tray 3 and the first row of metallised articles K on the supply tray 20.

With a movement towards to the first switching axis Z, the first arms 510a are disengaged from the first rows of articles K positioned on the supply tray 20 and on the transfer tray 3, respectively.

The supply tray 20 carrying the metallised articles K is moved away along the supply line 2 and replaced by a new supply tray 20 carrying a second row of articles K to be metallised.

The transfer tray 3 is instead held in the supply position SP, to receive the second row of articles K to be metallised while the second row of metallised articles K is transferred to the supply line 2, with an operating sequence similar to that described above.

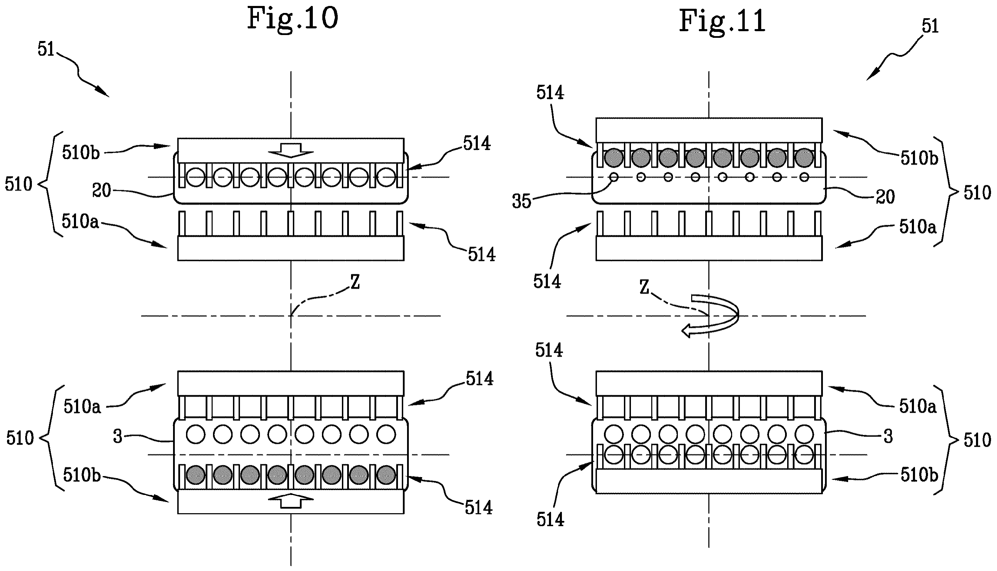

More particularly, with reference to figure 10, the second arm 510b of the grasping member 510 in the first position translates towards the first switching axis Z towards the second row of articles K to be metallised carried by the supply tray 20 to engage and remove them from the supply line 2.

At the same time, the second arm 510b of the other grasping member 510 translates towards the first switching axis Z to engage the second row of already metallised articles K (illustrated in grey in figure 10), carried by the transfer tray 3 in the supply position SP.

Following a lifting motion imposed on the second arms 510b, the second rows of articles K are respectively removed from the supply tray 20 and the transfer tray 3.

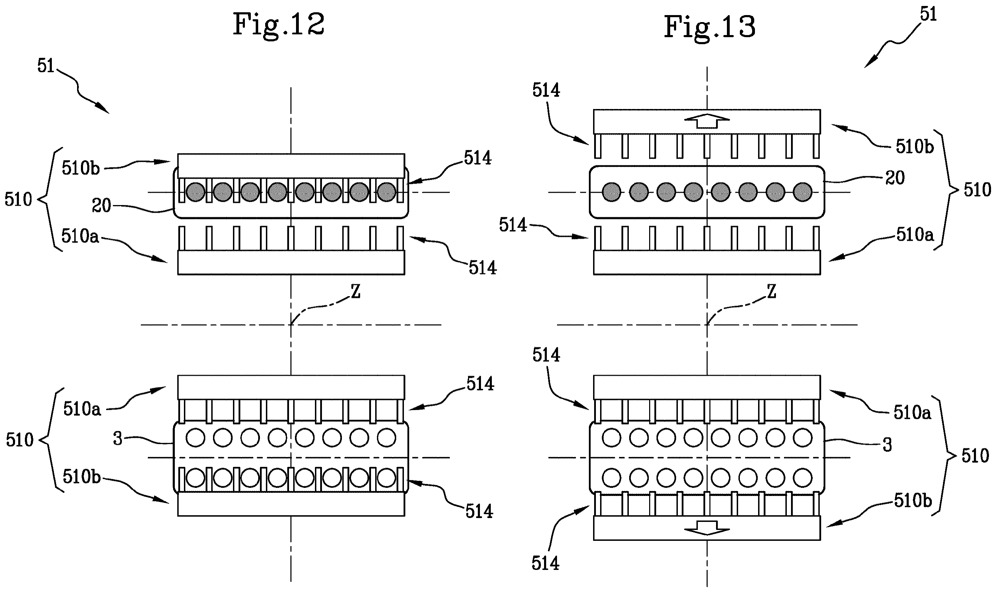

With reference to figure 11, with a 180° rotation of the grasping members 510 about the first switching axis Z, the second row of articles K to be metallised takes the place of the second row of metallised articles K (illustrated in grey in figure 11), and vice versa. A possible radial translation of the second arms 510b (figure 12) brings the articles K into axial alignment with the respective support members 30 carried by the transfer 3 and supply 20 tray, after which a new downward movement imposed on the second arms 510b positions the second row of articles K to be metallised on the transfer tray 3 and the second row of metallised articles K on the supply tray 20.

With reference to figure 13, with a movement away from the first switching axis Z, the second arms 510b are disengaged from the second rows of articles K positioned on the supply tray 20 and on the transfer tray 3, respectively.

The supply tray 20 carrying the metallised articles K is moved away along the supply line 2 and replaced by a new supply tray 20 carrying a new first row of articles K to be metallised. At the same time, in the supply position SP, the transfer tray 3 loaded with the articles K to be metallised is replaced with a next transfer tray 3 carrying the metallised articles K.

Between the transfer position TP and the loading/unloading position LU a second manipulator 52 operates which is configured to transfer to the decoration module 4 each treatment tray 3 arranged along the transfer path T and carrying the articles K previously transferred from the first manipulator 51.

More specifically, in a manner known per se and therefore not further described, the second manipulator 52 is provided with two movable gripping members 520 with 180° rotations around a second switching axis W, by means of which it lends itself to operating simultaneously on:
a treatment tray 3 carried by the transferor 50 of the transfer unit 5 to transfer it from the transfer position TP to the loading/unloading position LU;
a treatment tray 3 carried by the handler 6 of the decoration module 4, to transfer it from the loading/unloading position LU to the transfer position TP.

In other words, a treatment tray 3 in the loading/unloading position LU carrying already processed articles K is exchanged with a treatment tray 3 in the transfer position TP carrying articles K to be processed.

The treatment tray 3 transferred by means of the second manipulator 52 from the loading/unloading position LU to the transfer position TP is subsequently carried by the transferor 50 to the supply position SP, to be subjected to the action of the first manipulator 51.

A possible embodiment variant of the invention provides that, unlike to what is described above, the support members 30 of each treatment tray are positioned along a single row, so as to removably engage a plurality of articles K arranged along a single row, preferably parallel to an advancement direction of the treatment tray 3.

Specifically, each treatment tray 3 is engaged on the handler 6 of the decoration module 4 oriented with the single row of articles K arranged in parallel to the working path L.

The first metallising device 71 and the second metallising device 81 are configured to perform the first and second metallisation processing substantially identically on the articles K arranged along the single row, with better results in qualitative terms. The second metallisation processing performed on the already metallised articles K allows in fact to finish and perfect the metallisation of the article K obtained through the first metallisation processing.

Alternatively, the second metallisation processing may be different from the first metallisation processing.

The possibility of performing two different metallisation processings on the same article K offers the possibility of further embellishing the articles K, for example with alternative aesthetic and chromatic effects obtainable by deposition of respectively different metals.

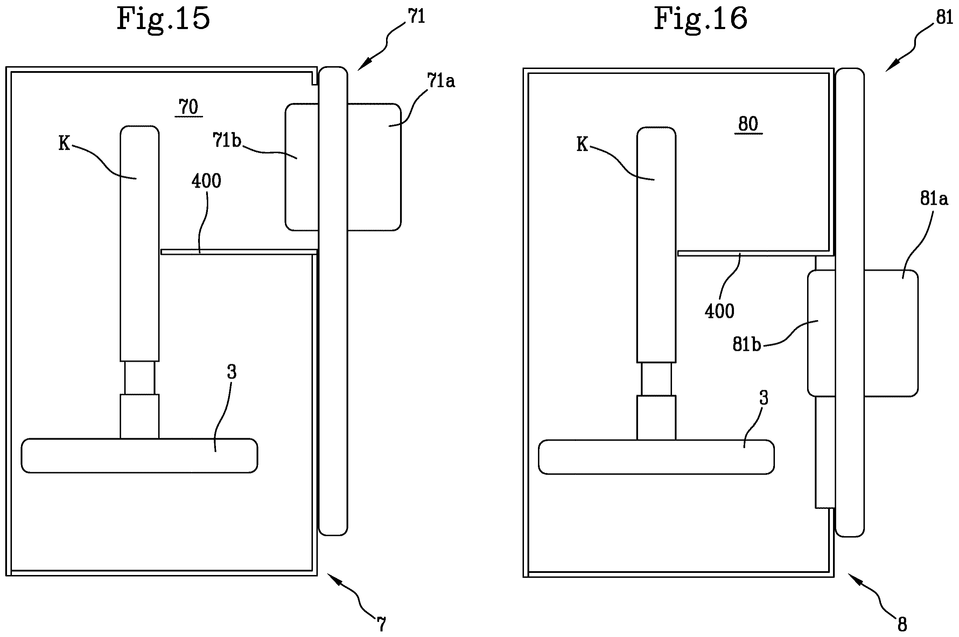

In a possible embodiment, illustrated in figures 15 and 16, the decoration module 4 may comprise at least one deflector element 400 designed to shield a predetermined portion of each article K from the projection of particles, by intercepting the metal particles directed towards said portion. The deflector element 400 may be arranged in one of said first workstation 70 and second workstation 80, or both chambers may each be provided with a respective deflector element 400, to intercept metal particles directed towards predetermined and different portions of each article K. For example, the deflector elements 400 installed respectively in the first workstation 70 and in the second workstation 80 may be configured to intercept the metal particles directed respectively towards a lower portion and an upper portion of each article K.

When using treatment trays 3 carrying the articles K arranged in a single row, the transfer of the articles K from the supply line 2 to the decoration module 4 can be carried out directly by the second manipulator 52, in the absence of the transferor 50 and the first manipulator 51, by positioning the loading/unloading region R of the supply line 2 near the loading/unloading position LU of the working path L.

Advantageously, the present invention is capable of overcoming the drawbacks emerging from the prior art.

Advantageously, the apparatus 1 has increased efficiency and increased productivity thanks to the first 70 and the second 80 metallisation workstation and the treatment tray 3 designed to engage a plurality of articles K arranged along two rows placed in parallel side by side.

Advantageously, the apparatus 1 allows to obtain a high level of metallisation quality even in the case of articles K having a discontinuous and angular outer surface, thanks to the first 70 and the second 80 metallisation workstation and the treatment tray 3 designed to engage a plurality of articles K arranged along a single row or according to two parallel rows.

Advantageously, the apparatus 1 allows to obtain extremely distinguishable metallised articles K thanks to the first 70 and the second 80 metallisation workstation that allow to perform respective metallisation processings different from each other and to the treatment tray designed to engage a plurality of articles K arranged along a single row.

## Claims

1. Apparatus (1) for applying surface treatments to articles, comprising:
a plurality of treatment trays (3), each designed to removably engage a plurality of articles (K);
a decoration module (4), configured to apply a surface treatment to articles (K) carried by each of said treatment trays (3);
wherein the decoration module (4) comprises:
a handler (6) for said treatment trays (3), configured to move the treatment trays (3) along a working path (L);
at least a first treatment zone (7) arranged along the working path (L) and provided with a first workstation (70), designed to receive said treatment trays (3), and a first metallising device (71), arranged in the first workstation (70) and designed to perform a first metallisation processing on the articles (K) carried by the treatment tray (3) in the first workstation (70);
at least a second treatment zone (8) arranged along the working path (L) downstream of said first treatment zone (7) and provided with a second workstation (80), designed to receive said treatment trays (3), and with a second metallising device (81), arranged within the second workstation (80) and designed to perform a second metallisation processing on the articles (K) carried by the treatment tray (3) in the second workstation (80).

2. Apparatus (1) according to claim 1, wherein each treatment tray (3) is designed to removably engage a plurality of articles (K) arranged along two rows placed in parallel alongside one another.

3. Apparatus (1) according to one or more of the preceding claims, wherein each treatment tray (3) comprises a plurality of support members (30), each designed to removably engage one of said articles (K), wherein said support members (30) are positioned along two rows placed in parallel alongside one another.

4. Apparatus (1) according to claim 2 or 3, wherein each treatment tray (3) engaged on the handler (6) is oriented with said two rows of articles (K) arranged parallel to the working path (L), and wherein:
the first metallising device (71) is configured to perform a first metallisation processing on the articles (K) arranged along one of said two rows;
the second metallising device (81) is configured to perform a second metallisation processing on the articles (K) arranged along the other of said two rows.

5. Apparatus (1) according to one or more of the preceding claims, wherein the first (71) and the second (81) metallising device each comprise an energetic particle emitter (71a, 81a) and a target element (71b, 81b), and wherein the target element (71b) of the first metallising device (71) and the target element (81b) of the second metallising device (81) are placed laterally alongside a portion of the working path (L) and face it in respectively opposite directions.

6. Apparatus (1) according to one or more of the preceding claims, wherein the first (71) and second (81) metallising devices each comprise an energetic particle emitter (71a, 81a) and a target element (71b, 81b); wherein the working path (L) extends according to a closed line; and wherein
the target element (71b) of the first metallising device (71) is placed inside said closed line and
the target element (81b) of the second metallising device (81) is placed outside the closed line.

7. Apparatus (1) according to one or more of the preceding claims, comprising a supply line (2), designed to supply a plurality of articles (K), and a transfer unit (5) operating:
on the articles (K) supplied by said supply line (2), to take them from the supply line (2) and transfer them to a treatment tray (3); and
on each treatment tray (3) carrying said transferred articles (K), to transfer said treatment tray (3) to the decoration module (4).

8. Apparatus (1) according to the preceding claim, wherein the transfer unit (5) operates on a first row of articles (K) to take it from the supply line (2) and transfer it to one of the treatment trays (3), and on a second row of articles (K) to take it from the supply line (2) and transfer it to the same treatment tray (3) placed in parallel alongside said first transferred row.

9. Apparatus (1) according to claim 7 and 8, wherein said transfer unit (5) comprises:
a transferor (50), designed to move a plurality of treatment trays (3) along a transfer path (T) between a supply position (SP), near the supply line (2), and a transfer position (TP), near the decoration module (4);
a first manipulator (51), operating close to the supply position (SP) to take the supplied articles (K) from the supply line (2) and transfer them to a treatment tray (3);
a second manipulator (52), operating close to the transfer position (TP) to transfer to the decoration module (4) each treatment tray (3) carrying said articles (K) transferred by the first manipulator (51).

10. Apparatus (1) according to claim 9, wherein the second manipulator (52) simultaneously operates on a treatment tray (3) carried by the transferor (50) to transfer it from the transfer position (TP) to a loading/unloading position LU arranged along the working path (L) of the decoration module (4), and on a treatment tray (3) carried by the decoration module (3), to transfer it from the loading/unloading position (LU) to the transfer position (TP).

11. Apparatus (1) according to claim 9 or 10, wherein the first manipulator (51) simultaneously operates on the articles (K) carried by one of the treatment trays (3), to transfer them to the supply line (2), and on the articles (K) carried by the supply line (2), to transfer them to the treatment tray (3).

12. Apparatus (1) according to one or more of the preceding claims, wherein the first (71) and the second (81) metallising devices are each designed to emit a beam of metal particles and wherein the decoration module (4) comprises at least one deflector element (400) arranged within at least one of said first (70) and second (80) workplaces and designed to intercept the metal particles directed towards a predetermined portion of each article (K).

13. Method for applying surface treatments to articles (K), comprising the following steps of:
preparing a plurality of articles (K);
transferring said articles (K) to a treatment tray (3) designed to removably engage a plurality of articles (K);
moving the treatment tray (3) carrying the articles (K) along a working path (L) and simultaneously performing a first and a second metallisation processing on said articles (K)
wherein the first and second metallisation processings are performed at respective treatment areas (7, 8) arranged consecutively along the working path (L).

14. Apparatus (1) according to claim 13, wherein the articles (K) are transferred onto a treatment tray (3) to form a first row and a second row placed in parallel alongside one another, the first and second metallisation processing being performed on the first and second rows of articles (K) respectively by projection of metal particles in respectively opposite directions.

15. Apparatus (1) according to claim 13 or 14, wherein the first and second metallisation processing are performed on a first portion and a second portion, respectively, of each of the articles (K) carried by the treatment tray (3).
